Europäisches Patentamt

European Patent Office

Office européen des brevets

(19)

(11) EP 1 020 990 A2

(12) **EUROPEAN PATENT APPLICATION**

(43) Date of publication:
    **19.07.2000 Bulletin 2000/29**

(51) Int Cl.⁷: **H03F 3/45**

(21) Application number: **99830379.6**

(22) Date of filing: **17.07.1999**

(84) Designated Contracting States:
    **AT BE CH CY DE DK ES FI FR GB GR IE IT LI LU
    MC NL PT SE**
    Designated Extension States:
    **AL LT LV MK RO SI**

(30) Priority: **18.01.1999 IT VA990002**

(71) Applicant: **STMicroelectronics S.r.l.
    20041 Agrate Brianza (Milano) (IT)**

(72) Inventors:
    • **Marchese, Stefano
      27100 Pavia (IT)**

    • **Bollati, Giacomino
      29015 Castel San Giovanni (IT)**
    • **Malfa, Maurizio
      20013 Pontenuovo Magenta (IT)**
    • **Savo, Pierandrea
      27100 Pavia (IT)**

(74) Representative: **Pellegri, Alberto et al
    c/o Società Italiana Brevetti S.p.A.
    Piazza Repubblica, 5
    21100 Varese (IT)**

(54) **MOS transconductor with broad trimming range**

(57)    A transconductor comprising a differential stage composed of a pair of input transistors, a resistive line of degeneration convecting the sources of the input transistors of said differential stage, a pair of bias current generators, each coupled between the source of a respective input transistor and a common ground node, has said resistive line of degeneration composed of one or more transistors in series, the gate of which is coupled to a voltage at least equal to the common mode voltage of the differential stage, and which are sized to operate in the triode region.

Fig.3

**EP 1 020 990 A2**

**Description**

BACKGROUND

The present invention relates to integrated electronic circuits and more in particular to time-continuous analog filters with a programmable cut off frequency.

The time constants of integrated systems have been traditionally implemented using transconductors and capacitors (T=C/gm).

Cut off programmability is realized by controlling the transconductance gain gm.

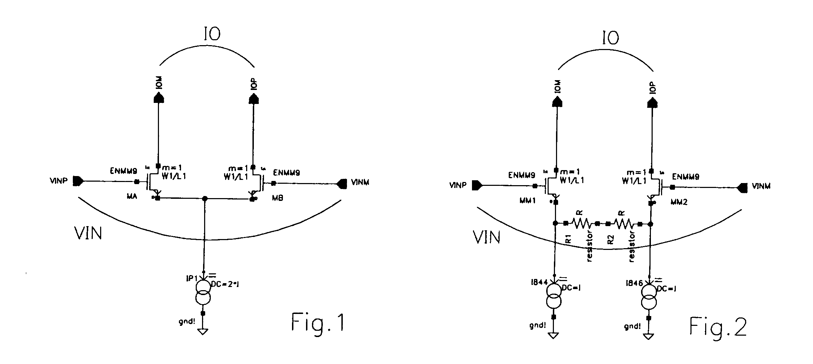

Fig. 1 shows the typical scheme of a CMOS differential transconductor for which the following equations apply:

$$ID = 1/2*u*Cox*W/L*Vod\hat{\ }2 \qquad where \qquad Vod=VGS-VTH \qquad (1)$$

$$gm = dID/dVGS = u*Cox*W/L*Vod \qquad (2)$$

where:

ID     is the drain current
u     is the mobility
Cox    is the specific capacitance of the oxide
W     is the channel width
L     is the channel length
Vod    is the so-called "overdrive" voltage of a MOS transistor.

For a given transistors dimensioning (W/L), the maximum value of the transconductance gain gm is limited by the fact that the overdrive voltage Vod of the differential stage cannot exceed a certain value, otherwise the bias current generator of the stage could be turned off.

By contrast, the minimum value of the current gain gm is limited by the fact that if the overdrive voltage Vod decreases, for the same amplitude of the input signal, the distortion that is introduced on the output current delivered by the transconductor stage increases.

Indeed, the current output by the transconductor is directly proportional to the input voltage Vin only if such current is relatively small if compared to the overdrive voltage Vod.

The distortion caused by the transconductor at relatively low values of the Vod overdrive voltage may be reduced by introducing, for this purpose, a number of degeneration resistors, as shown in the scheme of Fig. 2.

By defining gml as the transconductance of the single input MOS transistor, the stage transconductance may be expressed as:

$$gm = gm1/(1+R*gm1) \qquad (3)$$

In the known structure of Fig. 2, part of the input signal drops on the degeneration resistance and therefore, for the same amplitude of the input signal, the voltage vgs between the gate and the source has a reduced excursion and a reduced distortion introduced, according to the expression:

$$vgs = vi*1/gm(R+1/gm) = vi/(1+R*gm) \qquad (4)$$

For the same absorbed power and overdrive, a greater linearity is obtained at the expense of a lower transconductance gain.

A disadvantage of this known structure is that the transconductance attenuation caused by the source degeneration resistance, introduced to improve the linearity at low overdrive levels, grows as the overdrive voltage increases. The result is a contraction of the trimming range of the circuit.

OBJECT AND SUMMARY OF THE INVENTION

It has now been found a way to overcome these limitations and drawbacks of the known circuits.

The novel solution is based on the use of a degeneration resistance that decreases upon increasing the overdrive voltage (indeed, at high overdrive voltage values, there are less distortion problems and thereby a lower degree of degeneration is acceptable).

This resolutive behavior is obtained by using as a resistive degeneration line one or more transistors in series that are sized such to function in a so-called triode region of their characteristic.

The gate of the transistor or of the transistors used to realize the resistive line of source degeneration of the differential pair of input transistors may be, according to a first embodiment, coupled to the common voltage mode of the differential stage so that the transistor(s) used to realize the resistive line of source degeneration may function with the same gate/source voltage (vgs) of the differential pair of input transistors.

As long as the drain-source voltage of the degeneration transistors remains lower than the overdrive Vod, they function in the triode region, behaving like resistances with a value defined by 1/gds (gds being the drain-source conductance).

In this way, the degeneration ratio is maintained constant irrespectively of the technological parameters (the spread of the fabrication process)

According to an alternative and preferred embodiment which further extends the trimming range of the transconductance stage, the gate of the transistor or of the transistors used to realize the resistive line of source degeneration of the differential pair of input transistors, are biased by a dedicated circuit.

By injecting on an R resistance of the bias circuit of the gate of the transistor or transistors used to realize the resistive line of source degeneration, a current proportional to the bias current of the differential pair (see equation 1), the degeneration resistance is proportional to

$$1/(Vod + k*Vod^2) \qquad where \qquad k=(R*u*Cox/2)*(W1/L1).$$

### BRIEF DESCRIPTION OF THE DRAWINGS

**Figures 1** and **2**, as already discussed above, represent the known schemes of a MOS transconductor;

**Figure 3** is a basic scheme of a MOS transconductor realized according to a first embodiment of the present invention.

**Figure 4** is a basic scheme of a MOS transconductor according to an alternative embodiment of the invention.

### DESCRIPTION OF SOME EMBODIMENTS OF THE INVENTION

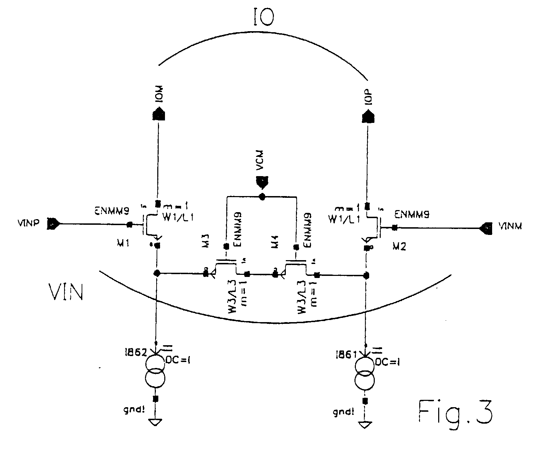

With reference to the scheme of Fig. 3, the following relationships may be derived:

$$gm1 = gm2 = u*Cox*W1/L1*Vod \qquad (5)$$

$$gds3 = gds4 = u*Cox*W3/L3*Vod \qquad (6)$$

Replacing R with 1/gds in equation (3), we obtain:

$$gm = gm1/(1+gm1/gds3) = gm1/(1+W1/L1/(W3/L3)) \qquad (7)$$

As it may be noticed, the stage transconductance varies linearly with the transconductance of the transistor M1 of the differential input pair.

Therefore, it is possible to considerably extend the trimming range of the transconductor for a certain permitted maximum distortion.

For instance, supposing that compatibly with the linearity specifications, the overdrive voltage Vod of the circuit is programmable in the 1-3 range, by using a structure of the invention as that shown in Fig. 3, with gm=gds3, the same distortion limit may be satisfied with an overdrive voltage $Vod_{NEW}=1/2*Vod$.

In this way, it is possible to program the overdrive, and thus the stage transconductance, within a range 0.5-3, practically doubling the trimming range.

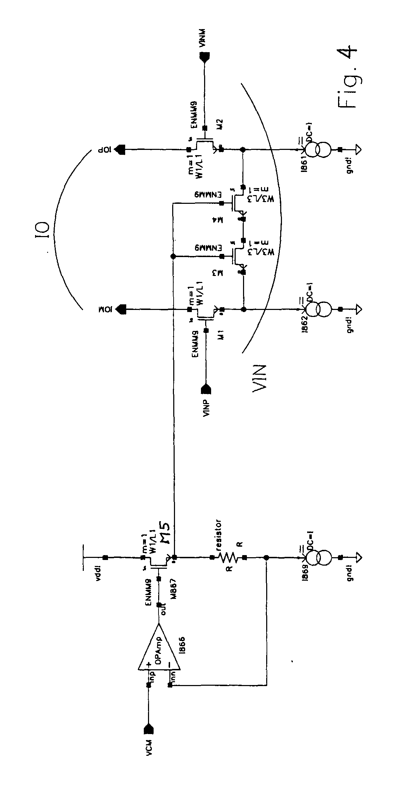

The scheme of Fig. 4, relates to an alternative embodiment of the invention. The following equation may be derived:

$$gm1 = gm2 = u*Cox*W1/L1*Vod \tag{8}$$

$$gds3 = gds4 = u*Cox*W3/L3*(Vod+k*Vod\textasciicircum2) \tag{9}$$

Replacing R with 1/gds in equation (3), we have:

$$gm = gm1/(1+gm1/gds3) = gm1/(1+W1/L1/(W3/L3)*1/(1+k*Vod)) \tag{10}$$

As it may be noticed, if the resistance had a zero value (k=0), the stage transconductance would vary linearly with the transconductance of the transistor M1 of the differential input pair, maintaining a constant degeneration ratio (gml/gds3) upon the varying of the gm value.

By introducing the term (k*Vod^2) in equation (9), it is made possible to have a degeneration ratio which decreases upon the increasing of the overdrive voltage.

Consequently, it is possible to considerably extend the trimming range of the transconductor for a certain admissible value of maximum distortion.

The gate voltage of the transistors that form the resistive line is generated by injecting a current proportional to the bias current of the differential pair M1-M2 on the resistance R of the dedicated bias circuit, having one of the terminals kept at the voltage VCM by the reaction loop constituted by the MOS transistor M5, the operational amplifier OpAmp and the resistance R itself.

The other terminal of the resistance R is connected to the source of the transistor M5 and is coupled to the gate of the MOS transistors M3 and M4 functioning in the triode region, which constitute the degeneration resistive line of the differential pair of transistors.

The voltage present on the source of the MOS transistor 867 is coupled to the gate of the MOS transistors operating in the triode region that constitute the degeneration resistive line of the differential pair.

## Claims

1. A transconductor comprising a differential stage composed of a pair of input transistors, a resistive line of degeneration connecting the sources of the input transistors of said differential stage, a pair of bias current generators, each coupled between the source of a respective input transistor and a common ground node, characterized in that said resistive line of degeneration is composed of one or more transistors in series, the gate of which is coupled to a voltage at least equal to the common mode voltage of the differential stage, and which are sized to operate in the triode region.

2. The transconductor according to claim 1, characterized in that the gate of the transistor or transistors that constitute said resistive line of degeneration is coupled to a voltage equal to the common mode voltage of the differential stage, to which is added an amount equal to the product between a certain constant (k) defined by design parameters and the squared value of the overdrive voltage (Vod).

3. The transconductor according to claim 2, characterized in that all said transistors of said resistive line of degeneration are MOS transistors biased with an overdrive voltage equal to the sum of the overdrive voltage (Vod) of the input transistors and of the product between said constant (k) and the squared value of said overdrive voltage of the differential pair of input transistors; the ratio between the transconductance gain of the transconductor and the drain-source resistance of said transistor or transistors of degeneration increasing with the increasing of the transconductance gain, thus incrementing the trimming range.

4. The transconductor according to claim 3, characterized in that it comprises

   a bias circuit of said transistors of degeneration functioning in the triode region, composed of an operational amplifier, the non inverting input of which is coupled to the common mode voltage of the differential stage;
   a transistor of identical characteristics of said input transistors of the differential input pair, having a gate coupled to the output of said operational amplifier, a resistor connected between the source of the transistor and, in common, to a generator of a bias current of said transistor, proportional to the bias current of the transconductor, and to the inverting input of said operational amplifier;

the gate of the transistor or transistors of said resistive line of degeneration being coupled to the source node of the transistor driven by the operational amplifier.

Fig.2

Fig.1

Fig.3

Fig. 4